# EUROPÄISCHE PATENTANMELDUNG

(11) **EP 3 854 907 A1**
(43) Veröffentlichungstag der Anmeldung: **28.07.2021**
(21) Anmeldenummer: 21153720.4
(22) Anmeldetag: 27.01.2021
(51) Int. Cl.: C23C 16/40, C23C 16/453, C08J 7/04, C08J 7/048, C09D 183/04, C09D 183/14, B32B 27/00

(54) **VERBUND MIT BARRIEREFUNKTION, DESSEN HERSTELLUNG UND VERWENDUNG**

(30) Priorität: 27.01.2020 DE 102020101797
(71) Anmelder: FRAUNHOFER-GESELLSCHAFT zur Förderung der angewandten Forschung e.V., 80686 München (DE)
(72) Erfinder: Amberg-Schwab, Sabine, 97082 Würzburg (DE); Somorowsky, Ferdinand, 97082 Würzburg (DE)
(74) Vertreter: Strehl Schübel-Hopf & Partner

(57) **Zusammenfassung**

Es werden ein Verbund, umfassend ein Substrat bzw. auch komplexe 3DGeometrien und eine darauf aufgebrachte Barriereschicht, die eine Metalloxidschicht aus einem flammenpyrolytisch abgeschiedenen Metalloxid und eine auf die Metalloxidschicht aufgebrachte Hybridpolymerschicht aus einem organisch modifizierten Kieselsäure(hetero)polykondensat aufweist, das mit dem flammenpyrolytisch abgeschiedenen Metalloxid kovalent verbundenen ist, sowie ein Verfahren zur Herstellung des Verbundes und Verwendungen des Verbundes bereitgestellt.

## Beschreibung

### Gebiet der Erfindung

Die vorliegende Erfindung betrifft einen Verbund mit einer Barriereschicht aus flammenpyrolytisch abgeschiedenem Metalloxid und damit kovalent verbundenem Hybridpolymer und dessen Herstellung und Verwendung.

### Stand der Technik

Kunststoffverpackungen enthalten Basispolymere, die nur ungenügende Barriereeigenschaften gegenüber Sauerstoff und Wasserdampf aufweisen. Deshalb müssen in die Verpackungsmaterialien Barriereschichten aus anderen Materialien eingebaut werden. Den Barriereschichten kommt bei Verpackungen eine besondere Bedeutung zu, denn Haltbarkeit und Sicherheit von kosmetischen und pharmazeutischen Produkten oder Lebensmitteln erfordern aufgrund der zu erfüllenden Eigenschaften häufig Hochleistungsverpackungen. Für Verpackungen im Lebensmittel- oder Pharmabereich gelten Höchstwerte für die Sauerstoffdurchlässigkeit (OTR) von 0,1 cm³/(m²∗d∗bar) und für die Wasserdampfbarriere (WVTR) von 0,1 g/(m²∗d). Für den technischen Bereich, z. B. für die Verpackung oder Verkapselung von Solarzellen, müssen Werte von < 10⁻³ cm³/(m²∗d∗bar) OTR oder < 10⁻³ g/(m²∗d) WVTR eingehalten werden.

Die für Verpackungs- bzw. Verkapselungsmaterialien eingesetzten Mehrschichtfolien mit ihrem komplexen Aufbau aus verschiedenen Materialien werden in einem Verfahrensschritt extrudiert bzw. in mehreren Verfahrensschritten über Applikation von Beschichtungen und/oder durch Kaschierprozesse hergestellt. Ein typischer Schichtaufbau besteht beispielsweise aus LDPE, das als Wasserdampfbarriere wirkt und als Siegelschicht aufgebracht ist, Polyamid, das die mechanische Belastbarkeit gewährleistet, und EVOH (Ethylen-Vinylalkohol-Copolymer) für eine ausreichende Barriere gegenüber Sauerstoff. Je nach Anforderung und gewünschtem Einsatzgebiet können sieben oder mehr unterschiedliche Materialien in einer Verbundfolie kombiniert sein. Neben den oben genannten polymeren Barrieren gegenüber Sauerstoff und Wasserdampf kommen auch anorganische (AlOₓ oder Silixiumoxid (SiOₓ)) oder metallische (Aluminium)-Schichten zum Einsatz, die eine Absenkung der Permeation und damit Erhöhung der Barrierewirkung um mehrere Größenordnungen gegenüber den nicht beschichteten Substraten ermöglichen.

Die anorganische oder metallische Schicht (beispielsweise SiOₓ, AlOₓ bzw. metallisches Al) wird üblicherweise auf ein Substrat appliziert, indem aufgedampfte oder aufgesputterte Schichten im Vakuum gebildet werden. Diese Technik hat jedoch die Nachteile, dass sie nur im Batchverfahren möglich ist und sie zu mechanischer Instabilität (Sprödigkeit) oder Defekten in der Sperrschicht führt und dadurch die Barriereleistung einschränkt. Die aufgedampften oder aufgesputterten sehr dünnen Sperrschichten von 20-70 nm können vor allem bei rauen Substraten ihr Barrierepotential nicht vollständig ausprägen. Um diesen Einschränkungen entgegenzuwirken, können zusätzlich nasschemische Beschichtungen aufgebracht werden, die Unebenheiten der zu beschichtenden Substrate ausgleichen, eine gute Haftung auf den Substraten und der anorganischen Schicht garantieren, mechanische Beständigkeit aufweisen sowie eine zusätzliche Barrierewirkung verleihen. Für leistungsfähige Barrierestrukturen sind insbesondere Kombinationen der im Vakuum aufgedampften Barriereschichten mit Sol-Gel-basierten Schichten möglich. Solche Schichten sind beispielsweise hybride Beschichtungen, z. B. ORMOCER®e, da diese unter anderem auf beiden Kontaktmaterialien, also auf polymeren Folien und der anorganischen bzw. metallischen Beschichtung, sehr gute Haftungseigenschaften und zusätzlich eine Barrierewirkung aufweisen. Die im Vakuum stattfindende Applikation der anorganischen bzw. metallischen Schicht erfolgt als physikalische Abscheidung aus der Gasphase (physical vapour deposition, PVD) oder durch chemische Abscheidung aus der Gasphase (vacuum chemical vapour deposition, VCVD). Die Nachteile der PVD-Verfahren sind vergleichsweise geringe Beschichtungsraten und langsame Beschichtungsgeschwindigkeit, eine anspruchsvolle Prozesstechnik aufgrund der Vakuumtechnik, hohe Anlagenkosten, Beschränkung auf Batchverfahren aufgrund der Vakuumapplikation der Schichten, hohe Produktionskosten und Schwierigkeiten bei der Beschichtung geometrisch komplexer Bauteile.

Neben dem Vakuumverfahren zum Aufbringen von anorganischen bzw. metallischen Barriereschichten gibt es die Möglichkeit, Metalloxide wie SiOₓ flammenpyrolytisch auf Oberflächen aufzubringen. Das Verfahren der Flammenpyrolyse oder CCVD (combustion chemical vapor deposition) gehört zur Gruppe der chemischen Gasphasenabscheidung oder CVD (chemical vapor deposition) und ermöglicht die Abscheidung funktioneller dünner Schichten bei Atmosphärendruck. Die Flammenpyrolyse ist bisher jedoch lediglich im Wesentlichen als Vorbehandlung für nachfolgende Beschichtungs-bzw. Verklebungsprozesse bekannt (z. B. PyroSil®, SiliCoater-Verfahren). Dabei wird auf unpolaren Oberflächen eine polare Grenzfläche erzeugt, wodurch die Haftung zu Klebstoffen oder Beschichtungen ermöglicht oder verbessert werden kann.

### Zusammenfassende Darstellung der Erfindung

Der vorliegenden Erfindung liegt die Aufgabe zugrunde, einen Verbund mit hervorragenden Barriereeigenschaften bereitzustellen, dessen Herstellung schnell, einfach und kostengünstig ist.

Versuche haben gezeigt, dass auch die durch Flammenpyrolyse (CCVD) bei Atmosphärendruck abgeschiedenen anorganischen Schichten zu deutlichen Barriereverbesserungen im Vergleich zu unbeschichteten Substraten führen können. Dieses Verfahren umgeht dabei auf einfache Weise die Nachteile der PVD-basierten Verfahren. Es wurde auch festgestellt, dass die Kombination von Hybridpolymerschichten mit den durch CCVD aufgebrachten Schichten zu überraschenden weiteren Barriereverbesserungen führt.

Die vorliegende Erfindung stellt die Gegenstände der folgenden Punkte (1) bis (15) bereit:
(1) Verbund, umfassend ein Substrat und eine darauf aufgebrachte Barriereschicht, die eine Metalloxidschicht aus einem flammenpyrolytisch abgeschiedenen Metalloxid und eine auf die Metalloxidschicht aufgebrachte Hybridpolymerschicht aus einem organisch modifizierten Kieselsäure(hetero)polykondensat aufweist, das mit dem flammenpyrolytisch abgeschiedenen Metalloxid kovalent verbunden ist, wobei das Substrat ein Verbundsubstrat aus einem Basissubstrat aus Kunststoff und einer auf einer oder zwei Seiten des Basissubstrats aufgebrachten Planarisierungsschicht aus einem organisch modifizierten Kieselsäure(hetero)polykondensat ist. Das Basissubstrat kann flächig sein, wobei die Planarisierungsschicht auf einer oder auf beiden seiner Flächenseiten aufgebracht sein kann. Wenn nur eine Seite des Basissubstrats die Planarisierungsschicht aufweist, ist das Metalloxid vorzugsweise auf der Planarisierungsschicht abgeschieden.
(2) Verbund nach Punkt (1), wobei das Metalloxid der Metalloxidschicht mit dem organisch modifizierten Kieselsäure(hetero)polykondensat sowohl der Hybridpolymerschicht als auch der Planarisierungsschicht kovalent verbunden ist.
(3) Verbund nach einem der vorstehenden Punkte, wobei das Substrat auf zwei Seiten die Barriereschicht aufweist.
   Die zwei Seiten können die beiden Flächenseiten eines flächigen Substrats sein. In der vorliegenden Erfindung sind die zwei Seiten eines Substrats gegenüberliegende Seiten, also z. B. Vorder- und Rückseite eines Substrats, und die gewünschte Barrierewirkung bezieht sich auf die Durchlässigkeit von der einer zu den anderen dieser zwei Seiten, im Fall eines flächigen Substrats also auf die Durchlässigkeit von der einen Flächenseite auf die andere Flächenseite.
   Eine Kombination der Merkmale der Punkte (1) bis (3) ist bevorzugt.
(4) Verbund nach einem der vorstehenden Punkte, wobei das Basissubstrat auf zwei Seiten, vorzugsweise auf beiden Flächenseiten eines flächigen Basissubstrats, die Planarisierungsschicht und die Barriereschicht aufweist.
(5) Verbund nach einem der vorstehenden Punkte, wobei die Verbundstruktur eine Behälterwand, ein Behälterboden und/oder ein Behälterdeckel ist, die/der auf der Außenseite die Planarisierungsschicht und auf der Innenseite die Barriereschicht aufweist.
(6) Verbund nach einem der vorstehenden Punkte, wobei die Planarisierungsschicht oder jede der Planarisierungsschichten eine mittels Rasterelektronenmikroskopie gemessene Dicke von 50 nm bis 1,0 µm aufweist.
(7) Verbund nach einem der vorstehenden Punkte, wobei das Basissubstrat eine Kunststoffbehälterwand einer Dicke von 0,1 mm bis 5 mm oder eine Kunststofffolie einer Dicke von 10 µm bis 3 mm, vorzugsweise 50 µm bis 2 mm ist.
   In einem bevorzugten Verbund beträgt die Dicke des Basissubstrats 0,05 bis 5 mm, die Dicke der Metalloxidschicht 5 bis 200 nm und die Dicke der Hybridpolymerschicht 0,1 bis 10 µm.
   In einem weiteren bevorzugten Verbund beträgt die Dicke des Basissubstrats 0,1 bis 5 mm, die Dicke der Metalloxidschicht 20 bis 200 nm und die Dicke der Hybridpolymerschicht 0,5 bis 10 µm.
(8) Verbund nach einem der vorstehenden Punkte, wobei die Dicke der Metalloxidschicht 10 bis 80 nm ist. Wenn nur eine Seite des Basissubstrats die Planarisierungsschicht aufweist, ist das Metalloxid vorzugsweise auf der Planarisierungsschicht abgeschieden. In einem bevorzugten Verbund nach (8) beträgt die Dicke des Basissubstrats 50 µm bis 2 mm, die Dicke der Planarisierungsschicht 50 nm bis 1,0 µm und Dicke der Hybridpolymerschicht 1,0 bis 5,0 µm.
(9) Verbund nach einem der vorstehenden Punkte, wobei die Dicke der Metalloxidschicht 10 nm bis 200 nm ist und wobei das Metalloxid der Metalloxidschicht eine mittels Transmissionselektronenmikroskopie gemessene Teilchengröße des Metalloxids von mindestens 5 nm aufweist und/oder die Metalloxidschicht eine Oberfläche aufweist, die mittels Transmissionselektronenmikroskopie gemessene Vertiefungen von mindestens 5 nm enthält.
(10) Verbund nach einem der vorstehenden Punkte, wobei das Metalloxid Siliziumoxid (SiOₓ) ist.
(11) Verbund nach einem der vorstehenden Punkte, wobei der Verbund eine Sauerstoffpermeabilität (OTR) von höchstens 0,1 cm³/(m²∗d∗bar) sowie eine Wasserdampfpermeabilität (WVTR) von höchstens 0,1 g/(m²∗d) aufweist.
(12) Verbund nach einem der vorstehenden Punkte, wobei das Substrat oder, wenn vorhanden, das Basissubstrat einschichtig, vorzugsweise eine Monofolie ist.
(13) Verfahren zum Herstellen einer Verbundstruktur, umfassend die folgenden Schritte in der angegebenen Reihenfolge:
   (i) Bereitstellen eines Substrats, welches das Bereitstellen eines vorzugsweise flächigen Basissubstrats aus Kunststoff und das Auftragen einer Planarisierungsschicht aus einem organisch modifizierten Kieselsäure(hetero)polykondensats auf eine oder auf zwei Seiten, vorzugsweise auf die beiden Flächenseiten des Basissubstrats unter Bildung des Substrats umfasst,
   (ii) flammenpyrolytisches vorzugsweise kontinuierliches, Abscheiden von Metalloxid, vorzugsweise Siliziumoxid (SiOₓ) auf das Substrat vorzugsweise bei Atmosphärendruck unter Bildung einer Metalloxidschicht,
   (iii) Auftragen eines organisch modifizierten Kieselsäure(hetero)polykondensats auf die Metalloxidschicht unter Bildung einer Hybridpolymerschicht,
   (iv) Ausbilden von kovalenten Bindungen zwischen dem organisch modifizierten Kieselsäure(hetero)polykondensat und dem Metalloxid.
   Bevorzugt ist die Kombination aus flächigem Basissubstrat, SiOₓ und Atmosphärendruck.
(14) Verfahren nach Punkt (13), wobei in Schritt (ii) die Temperatur so eingestellt wird, dass das Basissubstrat nicht aufgeschmolzen wird.

Das Einstellen der Temperatur kann das Kühlen des Basissubstrat umfassen. Das Kühlen erfolgt beispielsweise auf der Rückseite, wenn die Flammenpyrolyse auf der Vorderseite erfolgt. (15) Verwendung des Verbundes nach einem der Punkte (1) bis (12) als Verpackungsmaterial, Korrosionsschutz, Tablettenbeschichtung oder Verkapselung von Lebensmitteln, Kosmetik, pharmazeutische Verpackungen, Barrierematerialien für technische Anwendungen ((opto)elektronischen Bauteile) oder für alle Anwendungen auf planen Oberflächen oder 3D Geometrien, bei denen leistungsstarke Barrierefunktionen benötigt werden.

Die vorliegende Erfindung stellt außerdem die Gegenstände der folgenden Aspekte [1] bis [15] bereit:
[1] Verbund, umfassend ein Substrat, vorzugsweise ein Polymersubstrat, und eine darauf aufgebrachte Barriereschicht, die eine Metalloxidschicht aus einem flammenpyrolytisch, vorzugsweise bei Atmosphärendruck, abgeschiedenes Metalloxid, vorzugsweise Siliziumoxid (SiOₓ), und eine auf die Metalloxidschicht aufgebrachte Hybridpolymerschicht aus einem organisch modifizierten Kieselsäure(hetero)polykondensat aufweist, das mit dem flammenpyrolytisch abgeschiedenen Metalloxid kovalent verbunden ist.
   Bevorzugt ist das Substrat ein Polymersubstrat und das Metalloxid SiOₓ.
[2] Verbund nach Punkt [1], wobei das Substrat ein Verbundsubstrat aus einem Basissubstrat und einer auf einer oder zwei seiner Seiten aufgebrachten Planarisierungsschicht aus einem organisch modifizierten Kieselsäure(hetero)polykondensat ist.
   Das Basissubstrat kann flächig sein, wobei die Planarisierungsschicht auf einer oder auf beiden seiner Flächenseiten aufgebracht sein kann.
[3] Verbund nach Punkt [2], wobei das Metalloxid der Metalloxidschicht mit dem organisch modifizierten Kieselsäure(hetero)polykondensat sowohl der Hybridpolymerschicht als auch der Planarisierungsschicht kovalent verbunden ist.
[4] Verbund nach einem der vorstehenden Aspekte, wobei das Substrat auf zwei Seiten die Barriereschicht aufweist.
   Die zwei Seiten können die beiden Flächenseiten eines flächigen Substrats sein. In der vorliegenden Erfindung sind die zwei Seiten eines Substrats gegenüberliegende Seiten, also z. B. Vorder- und Rückseite eines Substrats, und die gewünschte Barrierewirkung bezieht sich auf die Durchlässigkeit von der einer zu den anderen dieser zwei Seiten, im Fall eines flächigen Substrats also auf die Durchlässigkeit von der einen Flächenseite auf die andere Flächenseite.
   Eine Kombination der Merkmale der Aspekte [1] bis [4] ist bevorzugt.
[5] Verbund nach einem der vorstehenden Aspekte, wobei das Basissubstrat auf zwei Seiten, vorzugsweise auf beiden Flächenseiten eines flächigen Basissubstrats, die Planarisierungsschicht und die Barriereschicht aufweist.
[6] Verbund nach einem der vorstehenden Aspekte, wobei die Verbundstruktur eine Behälterwand ist, die auf der Außenseite die Planarisierungsschicht und auf der Innenseite die Barriereschicht aufweist.
[7] Verbund nach einem der vorstehenden Aspekte, wobei das Basissubstrat, das vorzugsweise einschichtig ist, eine Kunststoffbehälterwand einer Dicke von 0,1 bis 5 mm oder eine Kunststofffolie einer Dicke von 50 µm bis 2 mm ist.
   In einem bevorzugten Verbund beträgt die Dicke des Basissubstrats 0,1 bis 5 mm, die Dicke der Metalloxidschicht 5 bis 200 nm und die Dicke der Hybridpolymerschicht 0,1 bis 10 µm.
   In einem weiteren bevorzugten Verbund beträgt die Dicke des Basissubstrats 0,1 bis 5 mm, die Dicke der Metalloxidschicht 20 bis 200 nm und die Dicke der Hybridpolymerschicht 0,5 bis 10 µm.
[8] Verbund nach einem der vorstehenden Aspekte, wobei die Dicke der Metalloxidschicht 10 bis 200 nm ist und das Metalloxid der Metalloxidschicht eine mittels Transmissionselektronenmikroskopie gemessene Teilchengröße des Metalloxids von mindestens 1 nm, vorzugsweise mindestens 5 nm aufweist.
[9] Verbund nach einem der vorstehenden Aspekte, wobei die Dicke der Metalloxidschicht 10 bis 200 nm ist und die Metalloxidschicht eine Oberfläche aufweist, die mittels
   Transmissionselektronenmikroskopie gemessene Vertiefungen von mindestens 5 nm enthält. In einer Ausführungsform sind die Dicke der Metalloxidschicht 20 bis 200 nm und die Vertiefungen mindestens 10 nm.
[10] Verbund nach einem der vorstehenden Aspekte, wobei das Metalloxid Siliziumoxid (SiOₓ) ist.
[11] Verbund nach einem der vorstehenden Aspekte, wobei der Verbund eine Sauerstoffpermeabilität (OTR) von höchstens 0,1 cm³/(m²∗d∗bar) sowie eine Wasserdampfpermeabilität (WVTR) von höchstens 0,1 g/(m²∗d) aufweist.
[12] Verbund nach einem der vorstehenden Aspekte, wobei das Substrat oder, wenn vorhanden, das Basissubstrat einschichtig, vorzugsweise eine Monofolie ist.
   Eine Kombination der Merkmale der Aspekte [1] bis [4] und [12] oder der Aspekte [1] bis [5] und [12] ist bevorzugt.
[13] Verfahren zum Herstellen einer Verbundstruktur, umfassend die folgenden Schritte in der angegebenen Reihenfolge:
   (i) Bereitstellen eines Substrats, vorzugsweise eines flächigen Substrats, stärker bevorzugt eines flächigen Kunststoffsubstrats,
   (ii) flammenpyrolytisches, vorzugsweise kontinuierliches, Abscheiden von Metalloxid, vorzugsweise Siliziumoxid (SiOₓ) auf das Substrat vorzugsweise bei Atmosphärendruck unter Bildung einer Metalloxidschicht,
   (iii) Auftragen eines organisch modifizierten Kieselsäure(hetero)polykondensats auf die Metalloxidschicht unter Bildung einer Hybridpolymerschicht,
   (iv) Ausbilden von kovalenten Bindungen zwischen dem organisch modifizierten Kieselsäure(hetero)polykondensat und dem Metalloxid.
   Bevorzugt ist die Kombination aus flächigem Kunststoffsubstrat, SiOₓ und Atmosphärendruck.
[14] Verfahren nach Punkt [13], wobei Schritt (i) das Bereitstellen eines Basissubstrats, vorzugsweise eines flächigen Basissubstrats, stärker bevorzugt eines flächigen Kunststoffbasissubstrats, und das Auftragen eines organisch modifizierten Kieselsäure(hetero)polykondensats auf das Basissubstrat unter Bildung des Substrats umfasst.
[15] Verwendung des Verbundes nach einem der Aspekte [1] bis [12] als Verpackungsmaterial, Korrosionsschutz, Tablettenbeschichtung oder Verpackungen von Lebensmitteln oder Verkapselungen von (opto)elektronischen Bauteilen. Der Verbund kann als Verpackungsmaterial im Lebensmittel-, Pharma- und Kosmetikbereich eingesetzt werden. Ein spezielles Beispiel ist die Verwendung für Kaffeekapseln.

### Vorteile der Erfindung

Ein wesentlicher Vorteil der vorliegenden Erfindung ist es, dass durch den Einsatz des Flammenpyrolyseverfahrens (CCVD) herkömmlich unerlässliche Vakuum-Batch- PVD-Verfahren zur Aktivierung von Oberflächen nicht mehr notwendig sind. Die mittels CCVD abgeschiedene Metalloxidschicht dient der Aktivierung der Oberfläche und hat zudem eine Barrierewirkung. Diese Barrierewirkung kann in Kombination mit einer Hybridpolymerschicht weiter stark verbessert werden.

Durch die hervorragende Barrierewirkung dieser kombinierten Schichten muss das Substrat als solches keine Barrierewirkung haben, so dass hinsichtlich der Zusammensetzungen und Eigenschaften des Substrats keine besonderen Einschränkungen bestehen. Daher können als Substrate beispielsweise originäre Kunststoffe oder Rezyklate, Mehrschichtfolien oder Monofolien und Materialgemische oder Monomaterialien, aber auch Papier, Pappe, biobasierte und oder bioabbaubare Folien oder Metall eingesetzt werden.

Das erfindungsgemäße Verfahren der Bildung der Metalloxidschicht kann in einem kontinuierlichen Verfahren (z.B. Rolle-zu-Rolle-Prozess) durchgeführt werden und ermöglicht im Gegensatz zu den PVD-Verfahren zudem die Beschichtung von dreidimensionalen Verpackungen mit komplizierten Geometrien ohne Vakuum.

### Eingehende Beschreibung der Erfindung

Die erfindungsgemäßen Verbunde unterscheiden sich strukturell von herkömmlichen Verbunden, die durch Vakuumabscheidungsverfahren hergestellt wurden. Bei der flammenpyrolytischen Abscheidung (CCVD) ist beispielsweise bei Verwendung von SiOₓ als Metalloxid der Gehalt an Silanolgruppen an der äußeren Grenzfläche, den inneren Grenzflächen und Oberflächen und im Bulk der SiOₓ-Schicht höher. Dies kann mittels Ramanspektroskopie, vorzugsweise Mikro-Ramanspektroskopie, IR-Spektroskopie und Festkörper-NMR-Spektroskopie nachgewiesen werden. Außerdem erfolgt bei der Flammenpyrolyse eine partikuläre Abscheidung von Metalloxid. Die auf diese Weise gewachsenen Schichten zeigen eine charakteristische Struktur, die mittels TEM nachgewiesen werden kann. Weiterhin können die Unterschiede durch Detektion der chemischen Abweichungen mittels Röntgenphotoelektronenspektroskopie (XPS) (auch in Kombination mit einer Tiefenprofilierung) oder Mikrosonde ermittelt werden.

Die Metalloxidschicht und die Hybridpolymerschicht können unabhängig voneinander die jeweils darunterliegenden Schichten ganz oder teilweise bedecken. Die jeweiligen Dicken der Schichten sind nicht besonders eingeschränkt. Sie können in Abhängigkeit des Auftragungsverfahrens der Hybridpolymerschicht, der Beschaffenheit der Oberfläche des Substrats und der Verwendung der Beschichtung variieren.

In einer bevorzugten Ausführungsform des erfindungsgemäßen Verbundes ist das Substrat ein Verbundsubstrat aus einem vorzugsweise flächigen Basissubstrat und einer auf einer oder zwei seiner Seiten, im Fall eines flächigen Basissubstrats auf beiden seiner Flächenseiten aufgebrachten Planarisierungsschicht aus einem Hybridpolymer. Durch die Auftragung einer solchen Planarisierungsschicht, die auch schon über Barriereeigenschaften verfügt, kann die Barrierewirkung der Kombination aus Metalloxidschicht und Hybridpolymerschicht zusätzlich deutlich verbessert werden. Außerdem wird dadurch eine Primerwirkung erreicht. Auf diese Weise sind sehr hohe Verbundfestigkeiten auch auf Weichmacher-enthaltenden Folien (z.B. PLA) einstellbar. Durch das Verfahren wird eine Unabhängigkeit der Barriereleistung und Barriereeigenschaft vom zu beschichtenden Basissubtrat erreicht.

Das erfindungsgemäße Verfahren ermöglicht die Kombination von zwei bzw. drei chemisch verwandten Schichten, nämlich Metalloxidschicht (insbesondere bei Verwendung von Siliziumoxid), Hybridpolymerschicht und ggf. Planarisierungsschicht auf Basis von Hybridpolymeren. Durch die kovalenten Bindungen an den Grenzflächen der Schichten ergeben sich Synergieeffekte für maximale Barrierewirkung. Durch Synergieeffekte an der Grenzfläche der beiden Schichten erfolgt die Ausbildung von kovalenten Bindungen, (z.B. Si-O-Si), welche auch zur Kompensation eventueller Defekte und/oder Porositäten in den anorganischen Schichten und stabile Verzahnung der Schichten führen. Durch ausgezeichnete Benetzungseigenschaften und die kovalenten Anbindungen können auch die bei der Applikation durch CCVD entstehenden mikroskopischen Löcher (Pinholes, Cracks) in den SiOₓ-Schichten verschlossen werden. Auf diese Weise können die Barriereeigenschaften des Gesamtverbundes weiter verbessert werden. Weiterhin kann über angepasste Prozesstechnik auch die SiOₓ-Beschichtung von sehr temperaturempfindlichen Substraten ohne Eigenschaftsverluste realisiert werden. Es ist mit diesem Verfahren weiterhin auch möglich, spannungsfreie dickere Schichten von 80 - 150 nm, z. B. für den Hochbarrierebereich, ohne negative Beeinflussung der unterschiedlichsten zu beschichtenden Basissubstrate zu applizieren. Dadurch können Substrate für Verpackungszwecke und für technische Anwendungen auf sehr einfachem und kostengünstigem Weg ohne Vakuumtechnik und Vermeidung von Batchprozessen hergestellt werden. Durch Vermeidung von komplexer Vakuumprozesstechnik sind die Hürden für einen Übertrag dieser Technologie in die Produktion deutlich geringer als bei den PVD- bzw. CCVD-basierten Verfahren.

Durch die Bereitstellung der erfindungsgemäßen Verbunde können recycelbare bzw. je nach Basispolymer auch bioabbaubare Verpackungen hergestellt werden, die alle Produktanforderungen erfüllen können. Da das erfindungsgemäße Verfahren eine Kombination aus Oberflächenaktivierung, Primerwirkung und gleichzeitig Applikation der ersten Barriereschicht ist, können Vorbehandlungsschritte eingespart werden.

Zusammenfassend sind aus den Komponenten Basissubstrat (BS), Planarisierungsschicht (P), Metalloxidschicht (M) und Hybridpolymesrchicht (H) folgende erfindungsgemäße Verbunde möglich:
BS/M/H, BS/P/M/H, H/BS/M/H, P/BS/P/M/H, P/BS/M/H, P/BS/P/M/H, H/M/BS/M/H, H/M/BS/P/M/H, H/M/P/BS/P/M/H.
Bevorzugt sind folgende Verbunde: BS/P/M/H, P/BS/P/M/H, P/BS/M/H, P/BS/P/M/H, H/M/BS/P/M/H, H/M/P/BS/P/M/H.

Alle genannten Komponenten, nämlich BS, P, M und H, sind unmittelbar aufeinander, d. h. ohne Zwischenschicht oder Klebemittel oder dergleichen, angeordnet. Wenn zwei der Schichten P, M und H benachbart sind, sind sie kovalent miteinander verbunden.

Die erfindungsgemäßen Verbunde können diese Verbundstrukturen enthalten oder aus diesen bestehen. Sie können also Halbstrukturen darstellen und Bestandteile von größeren Strukturen sein. Beispiele davon sind Laminate, die weitere Strukturen, z. B. weitere Schichten, aufweisen. Beispielsweise können mehrere erfindungsgemäße Verbunde in einem Laminat vorliegen. Die Verbindung der erfindungsgemäßen Verbunde mit weiteren erfindungsgemäßen Verbunden oder mit weiteren anderen Strukturen kann kovalent oder nichtkovalent sein.

Gleichnamige Schichten bzw. Verbundstrukturen auf den entgegengesetzten Seiten des Basissubstrats können unterschiedliche Funktion und Beschaffenheit aufweisen. Die Funktion kann beispielsweise Barrierewirkung gegen Wasserdampf und/oder Sauerstoff und/oder Monomere sein. Die Beschaffenheit kann die Zusammensetzung, Dicke, Dichte und/oder Rauheit sein.

Wird ein Rezyklat als Basissubstrat beispielsweise im Lebensmittel- oder Arzneimittelbereich eingesetzt, muss das Basissubstrat zum Lebensmittel bzw. Arzneimittel hin, also auf der Innenseite, abgedichtet werden, so dass keine unerwünschten Stoffe in das Lebensmittel bzw. Arzneimittel migrieren. Auf der Außenseite kann das Basissubstrat mit einer Planarisierungsschicht (P) bzw. einer Hybridpolymerschicht (H) beschichtet sein, um seine Oberfläche zu glätten, so dass diese beispielsweise bedruckt werden kann. Eine weitere Funktion dieser Außenschicht kann darin bestehen, Abriebfestigkeit oder UV-Beständigkeit zu verleihen. Es kann also der Verbund H/BS/M/H, P/BS/P/M/H, P/BS/M/H oder P/BS/P/M/H bevorzugt sein, wobei besonders bevorzugt ist, dass in Bezug auf BS die höhere Anzahl der Schichten innen liegt.

Ein bevorzugter erfindungsgemäßer Verbund ist H¹/M¹/P¹/BS/P²/M²/H², wobei das Basissubstrat BS die Kunststoffwand einer Getränkeflasche aus recyceltem Material sein kann. Die Innenseite mit der Verbundstruktur H¹/M¹/P¹ muss Barrierewirkung nur gegen unerwünschte Stoffe, wie Monomere oder Weichmacher, aus dem Rezyklat aufweisen, während der Gesamtverbund Barrierewirkung gegen Sauerstoff und Wasserdampf und möglicherweise weitere Permeanten aufweisen muss. Daher kann der Verbundstruktur H¹/M¹/P¹ so ausgestaltet sein, dass sie geringere Barrierewirkung gegen Sauerstoff und Wasserdampf hat als die Verbundstruktur P²/M²/H² der Außenseite. Es kann aber umgekehrt auch bevorzugt sein, dass die Verbundstruktur H¹/M¹/P¹ der Innenseite gegen Sauerstoff und Wasserdampf eine höhere Barrierewirkung aufweist als die Verbundstruktur P²/M²/H² der Außenseite.

Diese Unterschiede ergeben sich beispielsweise aus unterschiedlichen Dicken oder Zusammensetzungen von P¹ und P² und/oder M¹ und M² und/oder H¹ und H². Die besonderen Vorteile dieses Verbundes sind, dass die Migration von Sauerstoff, Wasserdampf und dergleichen durch den Verbund erschwert wird und gleichzeitig die in dem Basissubstrat enthaltenen Monomere, Weichmacher und dergleichen eingeschlossen werden.

Bei einer Kombination von H/P/M spielt aufgrund von Synergieeffekten die jeweilige Dicke von H und P für die Barriere nur eine untergeordnete Rolle.

In der vorliegenden Erfindung werden die angegebene Sauerstoffpermeabilität nach DIN 53 380 (23°C, 50% r. h., relative Feuchtigkeit) und die angegebene Wasserdampfpermeabilität nach DIN 53 122 (23°C, 85% r. h., relative Feuchtigkeit) bestimmt.

### Substrat

Ein für den erfindungsgemäßen Verbund eingesetztes Substrat umfasst ein Basissubstrat und ggf. eine darauf aufgetragene Planarisierungsschicht. Das Basissubstrat ist vorzugsweise flächig, d. h., es weist eine Fläche mit einer Länge in x-Richtung und eine Breite in y-Richtung auf, die jeweils mindestens das Zehnfache der Dicke in z-Richtung ist. Das Basissubstrat kann aber auch eine komplexere dreidimensionale Struktur aufweisen.

Das Basissubstrat ist nicht besonders eingeschränkt und kann ein beliebiges beschichtbares Material sein. Voraussetzung für die Beschichtbarkeit ist ein fester Zustand oder ein Zustand, bei dem zumindest eine definierte und stabile Oberfläche vorhanden ist. Als Basissubstrate können Polymere, Papiere, Pappen, Metalle, Glas und dergleichen eingesetzt werden. Beispiele von Polymeren sind und flexible Kunststofffolien einer Dicke von 10 µm bis 2 mm, z. B. Verpackungsfolien. Weitere Beispiele von Polymeren sind zumindest in gewissem Maß steife und formstabile Kunststoffe einer Dicke von 0,5 mm bis 10 mm, z. B. Wände von Behältern, wie Getränkeflaschen. In diesem Zusammenhang bedeutet Behälterwand nicht nur die Seitenwände, sondern umfasst auch den Boden und den Deckel des Behälters. In der vorliegenden Erfindung gilt für das Material des Basissubstrats die Maßgabe, dass ein organisch modifiziertes Kieselsäure(hetero)polykondensat ausgeschlossen ist, so dass sich das Material des Basissubstrats sowohl von dem Material der Hybridpolymerschicht als auch dem Material der Planarisierungsschicht grundsätzlich unterscheidet. Da sowohl die Hybridpolymerschicht als auch die Planarisierungsschicht mindestens 50 Gewichtsprozent (≥ 50 Gew.-%) organisch modifiziertes Kieselsäure(hetero)polykondensat enthalten, ist jedoch nicht ausgeschlossen, dass das Basissubstrat bis zu weniger als 50 Gewichtsprozent (< 50 Gew.-%) organisch modifiziertes Kieselsäure(hetero)polykondensats enthält.

Ein Basissubstrat kann beispielsweise ein originäres Basissubstrat oder ein Rezyklat sein. Ein Rezyklat kann Verunreinigungen enthalten, also unerwünschte Stoffe, die für die gewünschte Funktion des Verbundes nicht erforderlich oder sogar nachteilig sind.

Ein Basissubstrat aus Kunststoff bedeutet, dass das Basissubstrat zu mindestens 50 Gew.-% aus Kunststoff besteht. Weitere Bestandteile können Partikel, Füllstoffe, Fasern und dergleichen sein.

Ein Beispiel eines Basissubstrats in Polymilchsäure (PLA).

In einem Rezyklat auf Kunststoffbasis können unerwünschte Additive, Weichmacher oder Monomere, nicht gebundene Katalysatorreste, Bioadditive etc. als Verunreinigungen enthalten sein. Ein Beispiel von Verunreinigungen ist ein Gehalt von mindestens 5 Gewichtsprozent an niedermolekularen Substanzen, wie Monomere oder Weichmacher, mit einem Molekulargewicht von weniger als 1000 Da. Ein originärer Kunststoff enthält Verunreinigungen, wie Monomere oder unerwünschte Weichmacher, nicht oder nur in sehr geringer Menge. Es können jedoch erwünschte Weichmacher, beispielsweise im Fall von Weich-PVC, in größeren Mengen enthalten sein.

In einem Rezyklat auf Papierbasis können unerwünschte kurzkettige Zuckerketten, Farbe oder Druckerschwärze als Verunreinigungen enthalten sein (MOSH/MOAH). Ein Beispiel von Verunreinigungen ist ein Gehalt von mindestens 5 Gewichtsprozent an niedermolekularen Substanzen mit einem Molekulargewicht von weniger als 1000 Da. Ein originäres Papier enthält Verunreinigungen nicht oder nur in sehr geringer Menge. Es gibt bei einigen Papiersorten auch einen nicht unerheblichen Polymeranteil oder Fremdkörperanteil z.B. von 40 %. Auch aus diesem können unerwünschte Moleküle migrieren und zu Eigenschaftsverlusten führen. Diese Papiere sind dann möglicherweise für bestimmte Anwendungen (z.B. Lebensmittelverpackungen) nicht einsatzfähig.

Als Substrate für Barriereverbunde werden herkömmlich Materialgemische und/oder mehrschichtige Substrate, z. B. Mehrschichtfolien, eingesetzt, um eine gewisse Barrierewirkung bereits ohne eine Barrierebeschichtung zu gewährleisten.

In der vorliegenden Erfindung kann als Basissubstrat ein einschichtiges Material, beispielsweise eine Monofolie, eingesetzt werden. Es kann auch ein Monomaterial eingesetzt werden, also ein Material mit einem Hauptpolymer, das mindestens 80 Gewichtsprozent, vorzugsweise 95 Gewichtsprozent des Materials ausmacht. Eine Monofolie aus Monomaterial kann bevorzugt sein.

### Metalloxidschicht

Die Metalloxidschicht wird flammenpyrolytisch (CCVD) abgeschieden und enthält Metalloxide. Der Ausdruck "Metalloxidschicht aus einem flammenpyrolytisch abgeschiedenen Metalloxid" bedeutet, dass die Metalloxidschicht aus dem flammenpyrolytisch abgeschiedenen Metalloxid besteht oder zu mindestens 50 Gewichtsprozent daraus besteht. Das Metalloxid wird durch die CCVD modifiziert, wobei beispielsweise Hydroxygruppen entstehen, die sich unter anderem auf der Oberfläche der abgeschiedenen Metalloxidteilchen befinden. Diese können kovalente Bindungen mit den Hybridpolymeren der benachbarten Schichten eingehen, so dass beispielsweise im Fall der Verwendung von SiOₓ als das Metalloxid zusätzliche -Si-O-Si-Bindungen gebildet werden. Die entstehende Schicht aus modifiziertem Metalloxid wird in der vorliegenden Erfindung einfach als Metalloxidschicht bezeichnet.

Metalloxide können SiO₂, SiO, MgO, CaO, TiO₂, ZnO oder MnO oder Gemische davon sein. Bevorzugt ist Siliziumoxid SiOₓ, das Siliziummonoxid (SiO) und Siliziumdioxid (SiO₂) enthält, so dass "x" also 1,0 bis 2,0 ist. Es sind auch Werte von über 2,0 möglich. Je höher die mittels XPS gemessene Dichte der Hydroxyfunktionalitäten der abgeschiedenen SiOₓ-Teilchen ist, desto größer ist "x". In einer Ausführungsform ist "x" größer als 2,0, vorzugsweise größer als 2,2, noch stärker bevorzugt größer als 2,5.

Die mittlere Dicke der Metalloxidschicht ist vorzugsweise 5 nm bis 200 nm, stärker bevorzugt 10 nm bis 100 nm oder 20 nm bis 100 nm. Für bestimmte Anwendungen, z. B. für den Hochbarrierebereich, können auch dickere Metalloxidschichten verwendet werden, die mit dem CCVD-Verfahren spannungsfrei aufgetragen werden können. Die Dicke der Schichten kann 80 nm bis 200 nm, vorzugsweise 80 nm bis 100 nm sein.

Bei der CCVD wird das Metalloxid in Teilchenform auf ein Substrat aufgetragen. Die Teilchengröße hängt von dem Abstand des Brenners von der Oberfläche ab. Aufgrund von Agglomerationseffekten nimmt die Teilchengröße mit zunehmendem Abstand zur Oberfläche zu. Die Teilchen haben vorzugsweise eine Größe (d. h. einen größten Durchmesser) von 1 nm bis 100 nm oder 2 nm bis 50 nm oder 2 bis 20 nm. Dabei entsteht eine raue Oberfläche der aufgetragenen Metalloxidschicht, die neben Defekten und porösen Bereichen auch Vertiefungen aufweist, die sich bis zur Substratoberfläche erstrecken können. Die Oberfläche kann Vertiefungen aufweisen, die sich in Bezug auf die höchsten Erhebungen der Metalloxidschichtoberfläche vorzugsweise mindestens 5 nm, stärker bevorzugt mindestens 10 nm in Richtung der Substratoberfläche erstrecken. Beispielsweise können bei einer Metalloxidschichtdicke von 5 nm bis 100 nm Vertiefungen vorhanden sein, die sich bis zur Substratoberfläche erstrecken.

Die mit einem CCVD-Verfahren abgeschiedene Metalloxidschicht weist einen Dichtegradienten auf, wobei die Metalloxidteilchen mit zunehmendem Abstand von der Oberfläche des Substrats weniger dicht gepackt sind, die Dichte also abnimmt. Beispielsweise kann die Dichte auf höchstens die Hälfte der Dichte unmittelbar an der Substratoberfläche abnehmen. Es können also in Richtung senkrecht zur Substratoberfläche Bereiche vorhanden sein, deren Dichte der Metalloxidschicht sich um mindestens den Faktor 2 unterscheiden.

Die Eigenschaften der Metalloxidschicht, z. B. deren Dicke und deren Oberflächenrauigkeit, werden mittels Transmissionselektronenmikroskopie ermittelt.

Die erfindungsgemäß verwendete flammenpyrolytische Abscheidung von Metalloxid kann mit den herkömmlich bekannten Verfahren durchgeführt werden. Sie erfolgt vorzugsweise bei Atmosphärendruck. Ihr Grundprinzip wird nachfolgend am Beispiel von Siliziumoxid (SiOₓ) erläutert und kann auf andere Metalloxide übertragen werden: Eine siliziumorganische Vorläufersubstanz wird in einer Flamme verbrannt. Dabei entstehen sehr kleine Nanopartikel aus SiOₓ, bei denen die Oberfläche auf Grund der Atmosphäre sehr viele OH-Gruppen aufweisen. Dadurch kommt es zu einer Agglomeration dieser Nanopartikel und deren Vernetzung, wodurch die Oberfläche des Substrats sehr hydrophil wird. Das Verfahren kann kontinuierlichen durchgeführt werden. Die Dicke der abgeschiedenen Schichten und deren Struktur können durch die Prozessparameter (Temperatur, Zeit, Gasfluss, Vorläufersubstanzen) gut gesteuert werden. Durch flammenpyrolytische Siliziumoxidabscheidung kann beispielsweise auf PET-Folien ein OTR-Wert von < 1 cm³/m²bar erreicht werden. Die SiOₓ-Schicht ist durch den speziellen Abscheideprozess sehr reich an oberflächlichen OH-Gruppen, die als chemische Anker für Haftgruppen anderer Substanzen dienen. Damit ist eine einfache, großflächige und kontinuierliche Vorbehandlung von z.B. Glas, Metallen, Papier, Pappe und auch Kunststoffen realisierbar.

### Die Hybridpolymerschicht

Der Ausdruck "Hybridpolymerschicht aus einem organisch modifizierten Kieselsäure(hetero)polykondensat" bedeutet, dass die Hybridpolymerschicht aus dem organisch modifizierten Kieselsäure(hetero)polykondensat besteht oder zu mindestens 50 Gewichtsprozent daraus besteht. Es können beliebige andere Stoffe, wie Partikel, Fasern, Vliese oder Kombinationen davon, enthalten sein. Das anorganische Kieselsäure(hetero)polykondensat, das mit organischen Gruppen modifiziert ist, die ggf. organisch polymerisiert sind, wird in der vorliegenden Erfindung manchmal einfach als Hybridpolymer bezeichnet. In dem erfindungsgemäßen Verbund ist die Hybridpolymerschicht dadurch modifiziert, dass das Hybridpolymer mit dem flammenpyrolytisch abgeschiedenen Metalloxid kovalent verbundenen ist. Diese modifizierte Schicht wird in der vorliegenden Erfindung einfach als Hybridpolymerschicht bezeichnet.

Die anorganische Komponente des Hybridpolymers besteht aus Siliziumkationen, gegebenenfalls in Kombination mit weiteren Kationen wie Aluminium, Zirkonium, Titan oder Bor sowie Kombinationen davon, die über Sauerstoffbrücken miteinander verknüpft sind und dabei ein Netzwerk bilden. Damit handelt es sich um organisch modifizierte Kieselsäureionen oder, im Falle der Anwesenheit weiterer Metallionen, um ein organisch modifiziertes Kieselsäureheteropolykondensat. Ein Beispiel für ein solches Heteropolykondensat ist ein Kondensat, das Silizium und Aluminium enthält. Als gemeinschaftlicher Begriff für die reinen Kieselsäurepolykondensate und die Heteroatome enthaltenden Polykondensate wird der Begriff Kieselsäure(hetero)polykondensat verwendet.

Das Hybridpolymer wird in der Regel durch hydrolytische Kondensation von Silanen, ggf. in Kombination mit co-kondensierbaren Verbindungen anderer Metallionen, erzeugt. Diese Silane können hydrolysierbare Gruppen wie Alkoxide oder Hydroxidgruppe tragen. Sie können aber auch über Kohlenstoff unmittelbar an Silizium gebundene organische Gruppen tragen. Diese Gruppen bleiben bei der hydrolytischen Kondensation an die jeweiligen Siliziumatome gebunden, so dass das Polykondensat mit den organischen Gruppen modifiziert ist.

Die organischen Gruppen können Derivate einer oder mehrerer Arten von natürlichen oder synthetischen organischen Polymeren sein. Die organischen Gruppen können zumindest teilweise über Si-C-Bindungen in das Kondensat eingebunden vorliegen. Die über Si-C-Bindungen in das Kondensat eingebundene organische Gruppen können thermisch oder photochemisch organisch polymerisierbare Gruppen sein, insbesondere Epoxygruppen. Die organischen Gruppen können aber auch über Sauerstoff an Silizium gebunden sein. Sie können biologisch abbaubar sein.

In der vorliegenden Erfindung werden als Hybridpolymere bevorzugt ORMOCER® eingesetzt, wobei dieser Begriff so verstanden werden soll, dass darunter sowohl herkömmliche ORMOCER® als auch bioORMOCER®, also biologisch basierte und/oder abbaubare ORMOCER®, fallen. Anstelle der in der vorliegenden Erfindung genannten ORMOCER® als Beispiele für bevorzugte Hybridpolymer können jedoch auch beliebige andere Hybridpolymere, z. B. solche mit Heterogruppen, eingesetzt werden, wenn nichts anderes angegeben ist.

Die Hybridpolymerschicht in dem erfindungsgemäßen Verbund ist vorzugsweise biologisch abbaubar. Die Si-O-Si-Bindungen sind in der Regel säurestabil, aber basenlabil, so dass die Barriereschicht abgebaut werden kann. Die Basenlabilität kann auch bei der Rezyklierung eines erfindungsgemäßen Verbundes ausgenutzt werden, indem das Hybridpolymer durch alkalisches Waschen von dem Substrat abgelöst wird. Auch durch eine Verringerung der Vernetzungsgrade, speziell des anorganischen Vernetzungsgrades (also der Si-O-Si- bzw. Si-O-Metall-Bindungen) kann die Bioabbaubarkeit eingestellt werden. Für die biologische Abbaubarkeit der Beschichtung ist es notwendig, dass ein möglichst großer Anteil, vorzugsweise mindestens 10 Gewichtsprozent, der organischen Gruppen, die in das anorganische Netzwerk des Hybridmaterials eingebunden sind, biologisch abbaubar ist. Daher weist vorzugsweise zumindest ein Teil der organischen Gruppen eine Kohlenwasserstoffkette mit 2 bis 8, vorzugsweise mit 2 bis 6 Kohlenstoffatomen auf, die sich zwischen zwei unter Ether-, Ester-, Amid-, und Urethangruppen ausgewählten Gruppen befindet. Insbesondere kann zumindest ein Teil der organischen Gruppen mindestens zwei Kohlenwasserstoffketten mit 2 bis 8 Kohlenstoffatomen aufweisen, die verzweigtkettig zueinander vorliegen. Besonders bevorzugt weist zumindest ein Teil der anorganischen, biologisch abbaubaren Gruppen die Komponente [O-(CH₂)ₘ-C(O)-O]n auf, worin m eine ganze Zahl zwischen 2 und 8 ist, n 0, 1, 2 oder 3 oder größer 3 ist und, sofern die genannte Komponente in der organischen, biologisch abbaubaren Gruppe mehrfach vorhanden ist, unterschiedliche Werte annehmen kann, mit der Maßgabe, dass n in der einzigen oder in mindestens einer der genannten Komponenten 1 oder größer 1 ist. Die organischen Gruppen können auch aus der Gruppe ausgewählt sein, die aus Polycaprolactontriol (fossilen Ursprungs aber biologisch abbaubar), Chitosan, Cellulose, Cellulosederivaten; Hemicellulosen und Cellulosebausteinen, Stärke, Proteine und weitere bioorganische Ressourcen besteht.

Die Hybridpolymerschicht in dem erfindungsgemäßen Verbund wird erzeugt, indem ein entsprechender Beschichtungslack auf das gewünschte Substrat aufgetragen wird. Enthält er Lösungsmittel, kann dieses bei Bedarf entfernt werden. Alternativ oder kumulativ ist eine thermische Nachbehandlung oder eine Bestrahlung mit Licht z. B. im UV-Bereich möglich. Konkret kann die Hybridpolymerschicht mit einem Verfahren hergestellt werden, welches das Auftragen einer Zusammensetzung, die optional in einem Verdünnungs- und/oder Lösungsmittel vorliegt und Hybridpolymer enthält, auf eine Metalloxidschicht, beispielsweise durch Sprühen, Schlitzdüse, Gravurwalze und das Trocknen und/oder das Aushärten der Zusammensetzung umfasst.

Die Hybridpolymerschicht kann neben den Hybridpolymeren andere Polymere und/oder Füllstoffe enthalten. Die Füllstoffe sind vorzugsweise inert und nicht chemisch reaktiv. Sie können aber auch eine aktive Funktion einnehmen (z.B. antimikrobielle Funktion, aktive Barrierefunktion). Sie sollten im hybriden Sol lösbar bzw. dispergierbar und nicht hygroskopisch sein und eine Partikelgröße haben, welche das optische Erscheinungsbild der Beschichtung nicht beeinflusst. Typische Füllstoffe sind Stärke, chemisch modifizierte Stärke, Dextrin, mikrokristalline Cellulose, unlösliche Cellulosederivate, sowie anorganische Verbindungen (z.B. Talk, TiO₂, SiO₂, Silikate, Tonmaterialien, unlösliche Carbonate und Phosphate). Der Anteil des Füllstoffes (vorzugsweise in einer Menge von 1 - 25 Gew.% der Beschichtung) ist abhängig vom Material. Stärke oder Dextrin verbessern die mechanischen Eigenschaften und erleichtern die Verarbeitbarkeit. Anorganische Füllstoffe wie Silikate, Aerosile, Stöberpartikel verbessern die Barriereeigenschaften.

Die mittlere Dicke der Hybridpolymerschicht ist vorzugsweise 500 nm bis 10 µm, stärker bevorzugt 1,0 bis 5,0 µm. Die Dicke der Schicht wird z.B. mittels Rasterelektronenmikroskopie ermittelt.

### Planarisierungsschicht

In dem erfindungsgemäßen Verbund kann ein Substrat enthalten sein, das aus einem Basissubstrat und einer Planarisierungsschicht besteht. Wenn das Basissubstrat eine raue Oberfläche hat, kann eine Planarisierungsschicht diese Oberfläche glätten. Die Planarisierungsschicht ist also vorzugsweise mindestens so dick, dass alle Oberflächenrauigkeiten des Basissubstrats abgedeckt werden. Es entsteht eine Oberfläche, die ausschließlich aus Planarisierungsschichtmaterial besteht. Die Planarisierungsschicht kann außerdem als Primerschicht dienen.

Die mittlere Dicke der Planarisierungsschicht ist vorzugsweise 50 nm bis 1,0 µm, stärker bevorzugt 100 nm bis 1,0 µm. Die Dicke der Schicht wird mittels Rasterelektronenmikroskopie ermittelt.

Durch den Einsatz einer Planarisierungsschicht kann sogar eine sehr dünne Metalloxidschicht mit einer Dicke von beispielsweise 20 bis 60 nm eine hohe Barrierewirkung haben. Die Planarisierungsschicht macht den Barriereaufbau unabhängig vom zu beschichtenden Basissubstrat. Dadurch können auch recycelte Polymere als Basispolymere eingesetzt werden, weil eine mögliche Migration von Monomeren aus dem Basispolymer verhindert werden kann und definierte Oberflächen durch die Beschichtung entstehen.

Die Planarisierungsschicht enthält mindestens 50 Gewichtsprozent eines Hybridpolymers oder besteht aus diesem. Sie kann neben dem Hybridpolymer beliebige andere Bestandteile enthalten, wie Partikel, Fasern, Vliese oder Kombinationen davon. Das Hybridpolymer der Planarisierungsschicht ist definiert wie das Hybridpolymer der Hybridpolymerschicht. Das Hybridpolymer der Hybridpolymerschicht und das Hybridpolymer der Planarisierungsschicht können in einem erfindungsgemäßen Verbund gleich oder verschieden sein.

### Beispiele

Es wurden die Sauerstoffbarrierewirkungen von erfindungsgemäßen Verbunden untersucht. Die Ergebnisse sind in Tabelle 1 zusammengestellt.

**Tabelle 1:**

| | Sauerstoffdurchlässigkeit (23 °C, 50 % r. h.) [cm³/(m²∗d∗bar)] | | |
|---|---|---|---|
| | Polyolefinfolie (Dicke: 200 µm) | Folie + SiOₓ (Dicke: 50 nm) | Folie + SiOₓ + ORMOCER® (Dicke: < 3 µm) |
| Variante 1 | 1400 | 958 | 20,6 |
| Variante 2 | 1400 | 92 | 0,35 |

Die SiOₓ-Beschichtung erfolgte unten folgenden Parametern: 55 mm Brennerabstand, 70 ° Brennerneigung, 800 mm/s Fahrgeschwindigkeit des Substrats durch die Abscheidungsanlage.

Die Ergebnisse zeigen, dass die Barrierewirkung durch Beschichtung eines Foliensubstrats mit SiOₓ mittels CCVD und Hybridpolymer deutlich erhöht werden kann. Insbesondere konnte gezeigt werden, dass erfindungsgemäße Verbunde die Sauerstoffdurchlässigkeit auf deutlich unter 1 cm³/(m²∗d∗bar) senken können.

Die Wasserdampfpermeation der Polyolefinfolie betrug 827 g/(m²∗d), die der Variante 2 (Folie + SiOₓ + ORMOCER®) betrug 2,2 g/(m²∗d).

Die Variante 1 und 2 unterscheiden sich unter anderem dadurch, dass bei Variante 2 die Temperatur so optimiert wurde, dass die Polyolefinfolie beim Auftragen des Metalloxids nicht angeschmolzen wurde. Durch Optimierung weiterer Parameter, wie der Brennerleistung bei gleichzeitiger Folienkühlung, der Brennerneigung, des Brennerabstandes, der Fahrgeschwindigkeit sowie der Additivkonzentration konnte eine möglichst dichtgepackte partikuläre SiOₓ-Schicht mit einer Sauerstoffdurchlässigkeit von unter 0,1 [cm³/(m²∗d∗bar)] erzielt werden.

Eine Erhöhung der Schichtdicke führte jedoch zu keiner Barriereverbesserung, da eine dickere Barriereschicht zu vermehrter Rissbildung und Sprödigkeit und damit zu Defekten neigte.

Aus diesen Ergebnissen kann geschlossen werden, dass auch die Barrierewirkung gegenüber Wasserdampf und gegenüber weiteren Permeanten in einem ähnlich guten Bereich liegt. Beispiele von Permeanten sind Aromastoffe oder MOSH (Mineral Oil Saturated Hydrocarbons (gesättigte Mineralölkohlenwasserstoffe)) und MOAH (Mineral Oil Aromatic Hydrocarbons (aromatische Mineralölkohlenwasserstoffe)), die im Mineralöl oder in Druckfarben vorkommen.

Außerdem wurden erfindungsgemäße Verbunde rasterelektronenmikroskopisch untersucht. Dazu wurde der Verbund Polyolefinfolie/SiOₓ/ORMOCER® hergestellt, der aus Polyolefinfolie als Substrat, einer darauf flammenpyrolytisch abgeschiedenen SiOₓ-Schicht einer Dicke von etwa 50 nm und einer darauf aufgebrachten ORMOCER®-Schicht einer Dicke von etwa 2,2 µm bestand. Die rasterelektronenmikroskopische Auswertung ergab eine gute Haftung zwischen der SiOₓ-Schicht und der ORMOCER®-Schicht. Die SiOₓ-Schicht zeigte ein einheitliches Erscheinungsbild und eine gute Anhaftung an das Substrat.

## Patentansprüche

1. Verbund, umfassend ein Substrat und eine darauf aufgebrachte Barriereschicht, die eine Metalloxidschicht aus einem flammenpyrolytisch abgeschiedenen Metalloxid und eine auf die Metalloxidschicht aufgebrachte Hybridpolymerschicht aus einem organisch modifizierten Kieselsäure(hetero)polykondensat aufweist, das mit dem flammenpyrolytisch abgeschiedenen Metalloxid kovalent verbunden ist, wobei das Substrat ein Verbundsubstrat aus einem Basissubstrat aus Kunststoff und einer auf einer oder zwei Seiten des Basissubstrats aufgebrachten Planarisierungsschicht aus einem organisch modifizierten Kieselsäure(hetero)polykondensat ist.

2. Verbund nach Anspruch 1, wobei das Metalloxid der Metalloxidschicht mit dem organisch modifizierten Kieselsäure(hetero)polykondensat sowohl der Hybridpolymerschicht als auch der Planarisierungsschicht kovalent verbunden ist.

3. Verbund nach einem der vorstehenden Ansprüche, wobei das Substrat auf zwei Seiten die Barriereschicht aufweist.

4. Verbund nach einem der vorstehenden Ansprüche, wobei das Basissubstrat auf zwei Seiten die Planarisierungsschicht und die Barriereschicht aufweist.

5. Verbund nach einem der vorstehenden Ansprüche, wobei die Verbundstruktur eine Behälterwand ist, die auf der Außenseite die Planarisierungsschicht und auf der Innenseite die Barriereschicht aufweist.

6. Verbund nach einem der vorstehenden Ansprüche, wobei die Planarisierungsschicht oder jede der Planarisierungsschichten eine mittels Rasterelektronenmikroskopie gemessene Dicke von 50 nm bis 1,0 µm aufweist.

7. Verbund nach einem der vorstehenden Ansprüche, wobei das Basissubstrat eine Kunststoffbehälterwand einer Dicke von 0,1 mm bis 5 mm oder eine Kunststofffolie einer Dicke von 10 µm bis 3 mm ist.

8. Verbund nach einem der vorstehenden Ansprüche, wobei die Dicke der Metalloxidschicht 10 bis 80 nm ist.

9. Verbund nach einem der vorstehenden Ansprüche, wobei die Dicke der Metalloxidschicht 10 nm bis 200 nm ist und wobei das Metalloxid der Metalloxidschicht eine mittels Transmissionselektronenmikroskopie gemessene Teilchengröße des Metalloxids von mindestens 5 nm aufweist und/oder
die Metalloxidschicht eine Oberfläche aufweist, die mittels Transmissionselektronenmikroskopie gemessene Vertiefungen von mindestens 5 nm enthält.

10. Verbund nach einem der vorstehenden Ansprüche, wobei das Metalloxid Siliziumoxid (SiOₓ) ist.

11. Verbund nach einem der vorstehenden Ansprüche, wobei der Verbund eine Sauerstoffpermeabilität (OTR) von höchstens 0,1 cm³/(m²∗d∗bar) sowie eine Wasserdampfpermeabilität (WVTR) von höchstens 0,1 g/(m²∗d) aufweist.

12. Verbund nach einem der vorstehenden Ansprüche, wobei das Substrat oder, wenn vorhanden, das Basissubstrat einschichtig ist.

13. Verfahren zum Herstellen einer Verbundstruktur, umfassend die folgenden Schritte in der angegebenen Reihenfolge:
(i) Bereitstellen eines Substrats, welches das Bereitstellen eines Basissubstrats aus Kunststoff und das Auftragen eine Planarisierungsschicht aus einem organisch modifizierten Kieselsäure(hetero)polykondensats auf eine oder auf zwei Seiten des Basissubstrats unter Bildung des Substrats umfasst,
(ii) flammenpyrolytisches Abscheiden von Metalloxid auf das Substrat unter Bildung einer Metalloxidschicht,
(iii) Auftragen eines organisch modifizierten Kieselsäure(hetero)polykondensats auf die Metalloxidschicht unter Bildung einer Hybridpolymerschicht,
(iv) Ausbilden von kovalenten Bindungen zwischen dem organisch modifizierten Kieselsäure(hetero)polykondensat und dem Metalloxid.

14. Verfahren nach Anspruch 13, wobei in Schritt (ii) die Temperatur so eingestellt wird, dass das Basissubstrat nicht aufgeschmolzen wird.

15. Verwendung des Verbundes nach einem der Ansprüche 1 bis 12 als Verpackungsmaterial, Korrosionsschutz, Tablettenbeschichtung oder Verkapselung von Lebensmitteln oder (opto)elektronischen Bauteilen.
